# EUROPÄISCHE PATENTANMELDUNG

(11) **EP 4 807 300 A1**
(43) Veröffentlichungstag der Anmeldung: **16.09.2026**
(21) Anmeldenummer: 26163870.4
(22) Anmeldetag: 11.03.2026
(51) Int. Cl.: F26B 5/04, F26B 3/28, F26B 9/06, H10F 71/00

(54) **VERFAHREN UND VORRICHTUNG ZUM TROCKNEN EINES HALBLEITER-LACKS AUF EINER GLASPLATTE**

(30) Priorität: 11.03.2025 DE 102025109257
(71) Anmelder: Muffler, Pirmin, 78359 Orsingen-Nenzingen BW (DE)
(72) Erfinder: Muffler, Pirmin, 78359 Orsingen-Nenzingen BW (DE)
(74) Vertreter: Patentanwälte und Rechtsanwalt Weiß, Arat & Partner mbB

(57) **Zusammenfassung**

Die Erfindung betrifft eine Vorrichtung zum Trocknen eines Halbleiter-Lacks auf einer Glasplatte (1) mit einer Stärke von 250 bis 300 µm mit einem Gehäuse, wobei in dem Gehäuse eine Ablage-Einrichtung (2) vorhanden ist, wobei die Ablage-Einrichtung (2) zur Auflage der Glasplatte (1) in einer Trocknungslage geeignet ist, wobei die Ablage-Einrichtung (2) aus zwei zueinander beabstandeten Haltern (3.1, 3.2) besteht, wobei in der Trocknungslage eine Unter-Hitzevorrichtung (4) von der ersten Seite auf die Glasplatte (1) hitzestrahlend ausgerichtet ist, wobei die Unter-Hitzevorrichtung (4) eine zur Unter-Hitzevorrichtung (4) konvex ausgeformte Hitzeverteilungsplatte (5) umfasst.

## Beschreibung

### Technisches Gebiet

Die Erfindung betrifft eine Vorrichtung zum Trocknen eines Halbleiter-Lacks auf einer Glasplatte nach dem Oberbegriff des Anspruchs 1 und 2 und ein Verfahren zum Trocknen eines Halbleiter-Lacks nach den Ansprüchen 8 und 9.

### Stand der Technik

Derartige Vorrichtungen zum Trocknen eines Halbleiter-Lacks auf einer Glasplatte sind bereits in vielfältiger Form und Ausgestaltung bekannt und gebräuchlich. So wird beispielsweise in der DE 10 2005 060 456 A1 ein Verfahren und eine Vorrichtung zur Beschichtung von Wafern, sowie verfahrensgemäß beschichteter Wafer offenbart, bei welchem in einer Kammer ein Wafer und eine Folie über der zu beschichtenden Seite des Wafers angeordnet wird, welche einen Bereich der Kammer von dem Bereich der Kammer, in welcher der Wafer angeordnet ist, abtrennt, und bei welchem die Umgebung des Wafers evakuiert und im durch die Folie abgetrennten Bereich anschließend ein Fluid eingefüllt wird, so dass der durch das Einfüllen des Fluids bewirkte Druckunterschied die Folie auf den Wafer aufpresst und mit der auf den Wafer aufgepressten Folie eine Kunststoffbeschichtung geschaffen wird.

Weiter wird auf die EP 2 366 194 A1 verwiesen. Dort wird ein Verfahren offenbart, das folgende Schritte aufweist:
- Vorsehen eines Halbleiter-Wafers, der eine Vorderseite und eine Rückseite aufweist;
- Herstellen eines integrierten elektronischen Schaltkreises oder von Halbleiterbauelement-Strukturen an der Vorderseite;
- Ausformen von radialen Schlitzen an einem Umfang des Wafers und auf der Vorderseite des Wafers durch Schneiden, Vereinzeln, Laserabtragung oder Ätzung, wobei die Schlitze durch Schneiden entlang der Z-Achse geformt sind, die senkrecht auf der Vorderseite des Wafers steht;
- Vorsehen einer Ausnehmung an der Rückseite des Wafers, um den Wafer mit einem ausgedünnten zentralen Bereich zu versehen, der eine erste Oberfläche an einer ersten Seite und eine zweite Oberfläche an einer zweiten Seite hat, wobei die erste Oberfläche die integrierten elektronischen Schaltkreise oder die Halbleiterbauelement-Strukturen aufweist, und wobei die zweite Oberfläche eine Rückseite der integrierten Schaltkreise oder der Halbleiterbauelement-Strukturen ist, und von zumindest einer Verstärkungsstruktur umgeben ist, und wobei die Ausnehmung derart vorgesehen ist, dass zumindest ein Fluid-Durchgang mit der Ausnehmung kommuniziert, wobei der Fluid-Durchgang durch eine der Schlitze vorgesehen ist und wobei der Fluid-Durchgang zwischen einer Außenfläche des Wafers und einer Innenfläche des Wafers vorgesehen ist.

### Aufgabe der Erfindung

Die Aufgabe der vorliegenden Erfindung ist es, die Nachteile aus dem Stand der Technik zu überwinden. Insbesondere soll bei der Bearbeitung eine Vorrichtung bereitgestellt werden, die zum Trocknen eines Halbleiter-Lacks auf einer Glasplatte mit einer Stärke von 250 bis 300 µm genutzt werden kann, wobei die durch die besonders dünne Stärke der Glasscheibe entstehenden Probleme der Belackungs-Trocknung abzustellen. Gerade die Glasplatte mit einer Stärke von 250 bis 300 µm hängt während des Trocknungsvorgangs durch, wodurch es zu unregelmäßigen Trocknungsergebnissen des Lacks kommen kann. Auch ist problematisch, dass die Trocknungstemperatur an der Glasplatte unterschiedlich hoch ankommt und die Güte der Trocknung beeinträchtigt.

### Lösung der Aufgabe

Zur Lösung der Aufgabe führen die Merkmale nach dem Anspruch 1, 2, 8 und 9. Vorteilhafte Ausgestaltungen sind in den Unteransprüchen beschrieben.

Eine erfindungsgemäße Vorrichtung zum Trocknen eines Halbleiter-Lacks auf einer Glasplatte mit einer Stärke von 250 bis 300 µm weist ein Gehäuse auf. In dem Gehäuse ist eine Ablage-Einrichtung vorhanden, wobei die Ablage-Einrichtung zur Auflage der Glasplatte in einer Trocknungslage geeignet ist, wobei die Ablage-Einrichtung aus zwei zueinander beabstandeten Haltern besteht, wobei in der Trocknungslage eine Unter-Hitzevorrichtung von der ersten Seite auf die Glasplatte hitzestrahlend ausgerichtet ist.

Trocknungslage definiert sich als Zeitpunkt, an dem die Glasplatte mit aufgebrachtem Halbleiter-Lack auf der Ablage-Einrichtung aufliegt und zum Trocknen bereit ist.

Dabei weist die Unter-Hitzevorrichtung eine zur Unter-Hitzevorrichtung konvex ausgeformte Hitzeverteilungsplatte auf. In gleicher Weise ist die Hitzeverteilungsplatte von der Unter-Hitzevorrichtung umfasst. Die konvexe Wölbung kann dabei an Bedürfnisse der jeweiligen Glasplatte und die unterschiedlichen Stärken und Bemaßung angepasst sein, damit eine optimale Verteilung der Hitze beziehungsweise der Trocknungstemperatur erfolgen kann.

In einem anderen nebengeordneten erfindungsgemäßen Ausführungsbeispiel weist die Unter-Hitzevorrichtung eine zur Unter-Hitzevorrichtung konvex ausgeformte Hitzeverteilungsplatte auf oder ist umfasst, wobei eine Ober-Hitzevorrichtung vorhanden ist und in der Trocknungslage die Oberhitze-Vorrichtung zu der Glasplatte hin konvex geformt ist und eine zusätzliche Trocknungsenergie einbringt.

Die Unterhitze-Vorrichtung im Bereich der zwei zueinander beabstandeten Halter weist eine höhere Temperatur auf, als mittig zwischen den zueinander beabstandeten Haltern. Dadurch ist eine noch bessere Anpassung der Temperatur und damit eine gleichmäßige Trocknung zu erreichen.

Die Oberhitze-Vorrichtung weist in einem anderen Ausführungsbeispiel eine 3 bis 10 % höhere Temperatur aufweist als die Unterhitze-Vorrichtung im Bereich der zwei zueinander beabstandeten Halter. Auch dies dient dem gleichmäßigeren Trocknungsergebnis.

Das Gehäuse weist zusätzlich eine Stickstoff-Spülung auf, wobei ein Stickstoff der Stickstoff-Spülung die mittlere Temperatur der Unterhitze-Vorrichtung aufweist. Auch die entsprechende erwärmte Stickstofftemperatur führt zu einer noch gleichmäßigeren Trocknung des Halbleiter-Lacks.

Zusätzlich wird vorgeschlagen, dass das Gehäuse vakuumisoliert ist der unter Vakuum steht.

Auch ist ein Zentralrechner zur Steuerung der Temperatur der Unterhitze-Vorrichtung und der und der Oberhitze-Vorrichtung vorhanden, um eine Justierung der Temperatur zur gleichmäßigen Trocknung des Halbleiter-Lacks zu erreichen.

Daneben wird ein Verfahren zur Trocknung eines Halbleiter-Lacks auf einer Glasplatte mit einer Stärke von 250 bis 300 µm in einem Gehäuse mit folgenden Schritten:
- die Glasplatte mit dem aufgebrachten Halbleiter-Lack wird auf eine Ablage-Einrichtung bestehend aus zwei zueinander beabstandeten Haltern aufgelegt;
- eine Unter-Hitzevorrichtung wird von der ersten Seite auf die Glasplatte hitzestrahlend ausgerichtet;
- eine konvex zu der Unter-Hitzevorrichtung ausgeformte Hitzeverteilungsplatte verteilt die Temperatur in einer definierten Form, sodass in einer Trocknungslage die Temperatur im Bereich der zwei zueinander beabstandeten Halter eine höhere Temperatur aufweist, als mittig zwischen den zwei zueinander beabstandeten Haltern.

Durch die konvex zu der Unter-Hitzevorrichtung ausgeformte Hitzeverteilungsplatte wird das Durchhängen welches bei besonders dünnen Glasplatten zu beobachten ist, kompensiert, sodass eine trotzdem eine gleichmäßige Trocknung erreicht werden kann.

Zusätzlich wird ein Verfahren zur Trocknung eines Halbleiter-Lacks eines Halbleiter-Lacks auf einer Glasplatte mit einer Stärke von 250 bis 300 µm in einem Gehäuse durch folgende Schritte:
- die Glasplatte mit dem aufgebrachten Halbleiter-Lack wird auf eine Ablage-Einrichtung bestehend aus zwei zueinander beabstandeten Haltern aufgelegt;
- eine Unter-Hitzevorrichtung wird von der ersten Seite auf die Glasplatte hitzestrahlend ausgerichtet;
- eine konvex zu der Unter-Hitzevorrichtung ausgeformte Hitzeverteilungsplatte verteilt die Temperatur in einer definierten Form, sodass in einer Trocknungslage die Temperatur im Bereich der zwei zueinander beabstandeten Halter eine höhere Temperatur aufweist, als mittig zwischen den zwei zueinander beabstandeten Haltern;
- wobei die Temperatur der Unter-Hitzevorrichtung im Bereich der zwei zueinander beabstandeten Halter höher ist, als mittig zwischen den beiden Haltern.

Vorteilhaft ist dabei, dass durch eine zweiseitige Trocknung des Halbleiter-Lacks auf der besonders dünnen Glasplatte die Trocknungszeit zusätzlich verringert und dabei das Trocknungsergebnis nicht beeinträchtigt.

Zusätzlich kann das Gehäuse einer Stickstoff-Spülung unterzogen werden und das Gehäuse wird außerdem unter Vakuum gesetzt.

Auch für die gleichmäßige Trocknung ist es vorteilhaft, wenn ein Stickstoff der Stickstoff-Spülung die mittlere Temperatur der Unterhitze-Vorrichtung aufweist.

### Figurenbeschreibung

Weitere Vorteile, Merkmale und Einzelheiten der Erfindung ergeben sich aus der nachfolgenden Beschreibung bevorzugter Ausführungsbeispiele sowie anhand der Zeichnungen; diese zeigen in:
- Figur 1: eine Vorrichtung zum Trocknen eines Halbeleiter-Lacks nach dem Stand der Technik;
- Figur 2: eine erfindungsgemäße Vorrichtung zum Trocknen eines Halbleiter-Lacks auf einer Glasplatte;
- Figur 3: ein weiteres erfindungsgemäßes Ausführungsbeispiel einer Vorrichtung zum trocknen eines Halbleiter-Lacks auf einer Glasplatte.

### Ausführungsbeispiel

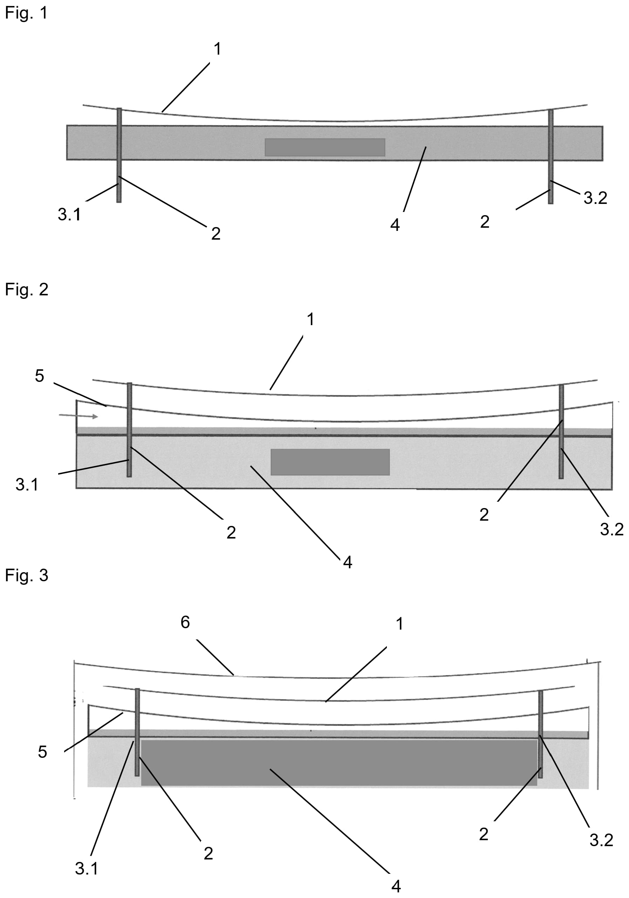

Die Figur 1 zeigt eine Vorrichtung nach dem Stand der Technik. Dort ist eine Glasplatte 1 mit einer Stärke von 250 bis 300 µm gezeigt. Auch ist eine Ablage-Einrichtung 2 vorhanden ist, wobei die Ablage-Einrichtung 2 zur gezeigten Auflage der Glasplatte 1 in einer Trocknungslage geeignet, wobei die Ablage-Einrichtung 2 aus zwei zueinander beabstandeten Haltern 3.1, 3.2 besteht, wobei in der Trocknungslage eine Unter-Hitzevorrichtung 4 von der ersten Seite auf die Glasplatte 1 hitzestrahlend ausgerichtet ist. Die durchhängende Glasplatte mit einer Stärke von 250 bis 300 µm führt dazu, dass an der tiefsten Stelle der durchhängenden Glasplatte 1 allein durch die Nähe zur Unter-Hitzevorrichtung 4 eine höhere Trocknungstemperatur auf die Glasplatte 1 beaufschlagt wird, als im Bereich der beiden zueinander beabstandeten Halter 3.1, 3.2.

Die Figur 2 zeigt eine erfindungsgemäße Vorrichtung zum Trocknen eines Halbleiter-Lacks auf einer Glasplatte 1, wobei die Glasplatte 1 eine Stärke von 250 bis 300 µm aufweist und ein nicht näher gezeigtes Gehäuse vorhanden ist. In dem Gehäuse ist eine Ablage-Einrichtung 2 vorhanden, wobei die Ablage-Einrichtung 2 zur Auflage der Glasplatte 1 in einer Trocknungslage geeignet ist, wobei die Ablage-Einrichtung 2 aus zwei zueinander beabstandeten Haltern 3.1, 3.2 besteht, wobei in der Trocknungslage eine Unter-Hitzevorrichtung 4 von der ersten Seite auf die Glasplatte 1 hitzestrahlend ausgerichtet ist.

Erfindungsgemäß umfasst die Unter-Hitzevorrichtung 4 eine zur Unter-Hitzevorrichtung 4 konvex ausgeformte Hitzeverteilungsplatte 5. Die Hitzeverteilungsplatte schafft durch die konvexe Form eine Parallele zur durch hängenden Glasplatte 1 und gleicht die beispielsweise in der Trocknungslage an der tiefsten Stelle der Glasplatte 1 vorherrschende hohe Trocknungstemperatur dadurch aus, die Temperatur über die gesamte Hitzeverteilungsplatte gleichmäßig verteilt wird.

In Figur 3 ist ein weiteres Ausführungsbeispiel gezeigt. Dort ist zusätzlich zu der in Figur 2 beschriebenen Anordnung der Unter-Hitzevorrichtung 4 und eine zur Unter-Hitzevorrichtung 4 konvex ausgeformte Hitzeverteilungsplatte 5 umfasst. Zusätzlich ist aber eine Ober-Hitzevorrichtung 6 vorhanden ist, wobei in der Trocknungslage die Oberhitze-Vorrichtung 6 zu der Glasplatte 1 hin konvex geformt ist. Dadurch wird von beiden Seiten eine gleichverteilte und in gleichem Abstand zur durchhängenden Glasplatte 1 geschaffen, was ein optimales Trocknungsergebnis zur Folge hat.

Zusätzlich kann die Unterhitze-Vorrichtung 4 im Bereich der zwei zueinander beabstandeten Halter 3.1, 3.2 eine höhere Temperatur aufweisen, als mittig zwischen den zueinander beabstandeten Halter 3.1, 3.2. Auch dadurch kann je nach Notwendigkeit und der Stärke der Glasplatte 1 oder des Halbleiter-Lacks eine bessere und gleichmäßigere Trocknung erreicht werden.

Das erfindungsgemäße Verfahren aus der Figur 2 zur Trocknung eines Halbleiter-Lacks auf einer Glasplatte 1 mit einer Stärke von 250 bis 300 µm erfolgt in dem nicht näher gezeigten Gehäuse und weist folgende Schritte auf:
- die Glasplatte 1 mit dem aufgebrachten Halbleiter-Lack wird auf die Ablage-Einrichtung 2 bestehend aus den zwei zueinander beabstandeten Haltern 3.1, 3.2 aufgelegt;
- die Unter-Hitzevorrichtung 4 wird von der ersten Seite auf die Glasplatte 1 hitzestrahlend ausgerichtet;
- die konvex zu der Unter-Hitzevorrichtung 4 ausgeformte Hitzeverteilungsplatte 5 verteilt die Temperatur in einer definierten Form, sodass in einer Trocknungslage die Temperatur im Bereich der zwei zueinander beabstandeten Halter 3.1, 3.2 eine höhere Temperatur aufweist, als mittig zwischen den zwei zueinander beabstandeten Haltern 3.1, 3.2.

Das erfindungsgemäße Verfahren aus der Figur 3 zur Trocknung eines Halbleiter-Lacks auf der Glasplatte 1 mit einer Stärke von 250 bis 300 µm in dem Gehäuse gekennzeichnet weist folgende Schritte auf:
- die Glasplatte 1 mit dem aufgebrachten Halbleiter-Lack wird auf die Ablage-Einrichtung 2 bestehend aus den zwei zueinander beabstandeten Haltern 3.1, 3.2 aufgelegt;
- die Unter-Hitzevorrichtung 4 wird von der ersten Seite auf die Glasplatte 1 hitzestrahlend ausgerichtet;
- die konvex zu der Unter-Hitzevorrichtung 4 ausgeformte Hitzeverteilungsplatte 5 verteilt die Temperatur in einer definierten Form, sodass in einer Trocknungslage die Temperatur im Bereich der zwei zueinander beabstandeten Halter 3.1, 3.2 eine höhere Temperatur aufweist, als mittig zwischen den zwei zueinander beabstandeten Haltern 3.1, 3.2;
- wobei eine Ober-Hitzevorrichtung 6 vorhanden ist, wobei in der Trocknungslage die Oberhitze-Vorrichtung 6 zu der Glasplatte 1 hin konvex geformt ist und hitzestrahlend ausgelegt wird.

Dadurch ist es vorteilhaft möglich, dass die Glasplatte von der Unter-Hitzevorrichtung 4 und der der Ober-Hitzevorrichtung 6 gleichmäßig mit Trocknungsenergie beaufschlagt wird und ein optimales Trocknungsergebnis erzielt wird.

Zusätzlich ist es vorsehbar, dass wobei die Temperatur der Unter-Hitzevorrichtung 4 im Bereich der zwei zueinander beabstandeten Halter 3.1, 3.2 höher ist, als mittig zwischen den beiden Haltern 3.1, 3.2.

### Bezugszeichenliste

| | |
|---|---|
| 1 | Glasplatte |
| 2 | Ablage-Einrichtung |
| 3 | Halter |
| 4 | Unterhitze-Vorrichtung |
| 5 | Hitzeverteilungsplatte |
| 6 | Ober-Hitzevorrichtung |

## Patentansprüche

1. Vorrichtung zum Trocknen eines Halbleiter-Lacks auf einer Glasplatte (1) mit einer Stärke von 250 bis 300 µm mit einem Gehäuse, wobei in dem Gehäuse eine Ablage-Einrichtung (2) vorhanden ist, wobei die Ablage-Einrichtung (2) zur Auflage der Glasplatte (1) in einer Trocknungslage geeignet ist, wobei die Ablage-Einrichtung (2) aus zwei zueinander beabstandeten Haltern (3.1, 3.2) besteht, wobei in der Trocknungslage eine Unter-Hitzevorrichtung (4) von der ersten Seite auf die Glasplatte (1) hitzestrahlend ausgerichtet ist,
**dadurch gekennzeichnet, dass**
die Unter-Hitzevorrichtung (4) eine zur Unter-Hitzevorrichtung (4) konvex ausgeformte Hitzeverteilungsplatte (5) umfasst.

2. Vorrichtung zum Trocknen eines Halbleiter-Lacks auf einer Glasplatte (1) mit einer Stärke von 250 bis 300 µm mit einem Gehäuse, wobei in dem Gehäuse eine Ablage-Einrichtung (2) vorhanden ist, wobei die Ablage-Einrichtung (2) zur Auflage der Glasplatte (1) in einer Trocknungslage geeignet ist, wobei die Ablage-Einrichtung (2) aus zwei zueinander beabstandeten Haltern (3.1, 3.2) besteht, wobei in der Trocknungslage eine Unter-Hitzevorrichtung (4) von der ersten Seite auf die Glasplatte (1) hitzestrahlend ausgerichtet ist,
**dadurch gekennzeichnet, dass**
die Unter-Hitzevorrichtung (4) eine zur Unter-Hitzevorrichtung (4) konvex ausgeformte Hitzeverteilungsplatte (5) umfasst, wobei eine Ober-Hitzevorrichtung (6) vorhanden ist, wobei in der Trocknungslage die Oberhitze-Vorrichtung (6) zu der Glasplatte hin konvex geformt ist.

3. Vorrichtung nach Anspruch 1 oder 2, **dadurch gekennzeichnet, dass** die Unterhitze-Vorrichtung (4) im Bereich der zwei zueinander beabstandeten Halter (3.1, 3.2) eine höhere Temperatur aufweist, als mittig zwischen den zueinander beabstandeten Haltern (3.1, 3.2).

4. Vorrichtung nach einem der Ansprüche 2 oder 3, **dadurch gekennzeichnet, dass** die Oberhitze-Vorrichtung (6) eine 3 bis 10 % höhere Temperatur aufweist als die Unterhitze-Vorrichtung (4) im Bereich der zwei zueinander beabstandeten Halter (3.1, 3.2).

5. Vorrichtung nach einem der vorigen Ansprüche, **dadurch gekennzeichnet, dass** das Gehäuse eine Stickstoff-Spülung aufweist, wobei die ein Stickstoff der Stickstoff-Spülung die mittlere Temperatur der Unterhitze-Vorrichtung (4) aufweist.

6. Vorrichtung nach einem der vorigen Ansprüche, **dadurch gekennzeichnet, dass** das Gehäuse vakuumisoliert ist.

7. Vorrichtung nach einem der vorigen Ansprüche, **dadurch gekennzeichnet, dass** ein Zentralrechner zur Steuerung der Temperatur der Unterhitze-Vorrichtung (4) und der und der Oberhitze-Vorrichtung (6) vorhanden ist.

8. Verfahren zur Trocknung eines Halbleiter-Lacks auf einer Glasplatte (1) mit einer Stärke von 250 bis 300 µm in einem Gehäuse **gekennzeichnet durch** folgende Schritte:
- die Glasplatte (1) mit dem aufgebrachten Halbleiter-Lack wird auf eine Ablage-Einrichtung (2) bestehend aus zwei zueinander beabstandeten Haltern (3.1, 3.2) aufgelegt;
- eine Unter-Hitzevorrichtung (4) wird von der ersten Seite auf die Glasplatte (1) hitzestrahlend ausgerichtet;
- eine konvex zu der Unter-Hitzevorrichtung (4) ausgeformte Hitzeverteilungsplatte (5) verteilt die Temperatur in einer definierten Form, sodass in einer Trocknungslage die Temperatur im Bereich der zwei zueinander beabstandeten Halter (3.1, 3.2) eine höhere Temperatur aufweist, als mittig zwischen den zwei zueinander beabstandeten Haltern (3.1, 3.2).

9. Verfahren zur Trocknung eines Halbleiter-Lacks auf einer Glasplatte (1) mit einer Stärke von 250 bis 300 µm in einem Gehäuse **gekennzeichnet durch** folgende Schritte:
- die Glasplatte (1) mit dem aufgebrachten Halbleiter-Lack wird auf eine Ablage-Einrichtung (2) bestehend aus zwei zueinander beabstandeten Haltern (3.1, 3.2) aufgelegt;
- eine Unter-Hitzevorrichtung (4) wird von der ersten Seite auf die Glasplatte (1) hitzestrahlend ausgerichtet;
- eine konvex zu der Unter-Hitzevorrichtung (4) ausgeformte Hitzeverteilungsplatte (5) verteilt die Temperatur in einer definierten Form, sodass in einer Trocknungslage die Temperatur im Bereich der zwei zueinander beabstandeten Halter (3.1, 3.2) eine höhere Temperatur aufweist, als mittig zwischen den zwei zueinander beabstandeten Haltern (3.1, 3.2);
- wobei eine Ober-Hitzevorrichtung (6) vorhanden ist, wobei in der Trocknungslage die Oberhitze-Vorrichtung (6) zu der Glasplatte hin konvex geformt ist und hitzestrahlend ausgelegt wird.

10. Verfahren nach Anspruch 8 oder 9, **dadurch gekennzeichnet, dass** die Temperatur der Unter-Hitzevorrichtung (4) im Bereich der zwei zueinander beabstandeten Halter 3.1, 3.2 höher ist, als mittig zwischen den beiden Haltern 3.1, 3.2.

11. Verfahren nach einem der Ansprüche 8 bis 10, **dadurch gekennzeichnet, dass** das Gehäuse einer Stickstoff-Spülung unterzogen wird und das Gehäuse unter Vakuum gesetzt wird.

12. Verfahren nach einem der vorigen Ansprüche 8 bis 11, **dadurch gekennzeichnet, dass** ein Stickstoff der Stickstoff-Spülung die mittlere Temperatur der Unterhitze-Vorrichtung (4) aufweist.
